# EUROPÄISCHE PATENTANMELDUNG

(11) **EP 4 488 406 A1**
(43) Veröffentlichungstag der Anmeldung: **08.01.2025**
(21) Anmeldenummer: 24182779.9
(22) Anmeldetag: 18.06.2024
(51) Int. Cl.: C23C 16/04, C23C 16/44, C23C 16/511

(54) **BESCHICHTUNGSSTATION FÜR DIE BESCHICHTUNG VON WERKSTÜCKEN MIT EINER BESCHICHTUNGSKAMMER UND MIT VERSORGUNGSLEITUNGEN ZUR VERSORGUNG DER KAMMER ODER EINES DARIN ANGEORDNETEN WERKSTÜCKES MIT EINEM BETRIEBSMEDIUM**

(30) Priorität: 03.07.2023 DE 102023117449
(71) Anmelder: KHS GmbH, 44143 Dortmund (DE)
(72) Erfinder: Brzezinski, Milosz, 44143 Dortmund (DE); Müller, Hartwig, 44143 Dortmund (DE); Herbort, Michael, 44143 Dortmund (DE)
(74) Vertreter: Eisenführ Speiser

(57) **Zusammenfassung**

Die Erfindung betrifft Beschichtungsstationen (1) für die Beschichtung von Werkstücken (5) in einem auf der Beschichtungsstation (1) ablaufenden Beschichtungsverfahren, wobei die Beschichtungsstation (1) wenigstens eine Beschichtungskammer (17) aufweist, die in einen geöffneten und einen geschlossenen Zustand überführbar ist und in die das zu beschichtende Werkstück (5) anordenbar ist zum Zwecke der Beschichtung, wobei die Kammer (17) von Kammerwänden (18, 29) gebildet ist, die Dichteinrichtungen (41) aufweisen, wobei die Kammer (17) dadurch im geschlossenen Zustand abgedichtet gegen die Außenumgebung verschließbar ausgeführt ist. Die Beschichtungsstation (1) weist einen oder mehrere Anschlüsse (42) auf für den Anschluss an wenigstens eine Unterdruckquelle (44, 49) und/oder Druckausgleichsquelle, jeweils als Betriebsmediumquelle für ein Betriebsmedium bezeichnet, wobei das Betriebsmedium und/oder alle Betriebsmedien innerhalb der Station (1) von dem Anschluss (42) bzw. von den Anschlüssen aus über eine zugeordnete, am Anschluss (42) beginnende Versorgungsleitung (54) für das Betriebsmedium zu der Kammer (17) und/oder zu dem Werkstück (5) geführt ist, wobei die Versorgungsleitung (54) dort ihr Leitungsende aufweist. Die Versorgungsleitung (54) teilt sich an wenigstens einer Zweigstelle (55), die zwischen ihrem Leitungsanfang und ihrem Leitungsende angeordnet ist, in Teilleitungen (46, 70, 80) auf, wobei in jeder Teilleitung (46, 70, 80) ein schaltbares Ventil (48) angeordnet ist.

## Beschreibung

Die Erfindung betrifft eine Beschichtungsstation nach dem Oberbegriff von Anspruch 1. In der Beschichtungsstation soll ein Werkstück nach einem Beschichtungsverfahren beschichtet werden. Ein typisches und bevorzugtes Beispiel ist die Beschichtung von Behältern, insbesondere die Innenschichtbeschichtung von Behältern. Ein typischer und bevorzugter Behälter ist z.B. eine Flasche aus einem thermoplastischen Kunststoff, z.B. aus PET. Insbesondere und bevorzugt ist gedacht an Beschichtungen, die mittels eines PECVD-Verfahrens aufgebracht werden, insbesondere mittels eines mikrowelleninduzierten PECVD-Verfahrens.

Bei solchen plasmabasierten Beschichtungsverfahren sind zur Ermöglichung der Ausbildung eines Plasmas Unterdruckbedingungen im Bereich des zu beschichtenden Werkstückes einzustellen. Bei einer Innenbeschichtung eines Behälters müssen im Behälterinneren Unterdruckbedingungen vorliegen, die eine Plasmaerzeugung erlauben, bei einer Au-ßenbeschichtung müssen entsprechend um den Behälter herum Unterdruckbedingungen eingestellt werden. Es sind im Stand der Technik vielfältige Verfahren und Vorrichtungen bekannt, um solche Unterdruckbedingungen einstellen zu können und um dann Beschichtungen abzuscheiden. Es sind im Stand der Technik ebenfalls in vielfältiger Art plasmabasierte Beschichtungsverfahren und Vorrichtungen bekannt, auf denen diese Verfahren ablaufen.

Bei Werkstücken, die nicht genügend Eigenstabilität aufweisen, um den einzustellenden Unterdruckbedingungen und insbesondere dem Druckunterschied zwischen dem Inneren und dem Äußeren standzuhalten, hat sich bewährt, um den Behälter herum eine Kammer anzuordnen und den zu beschichtenden Behälter in diese Kammer einzuführen und in der Kammer zu beschichten. Der Behälter wird dabei abgedichtet innerhalb der Kammer gehalten und die Kammer selber ist gegenüber derUmgebung abgedichtet. Das abgedichtete Halten des Behälters in der Kammer umfasst einerseits, dass das Behälterinnere gegenüber der umgebenden Kammer abgedichtet ist, aber auch gegenüber der Umgebung der Kammer. Es kann dann innerhalb des Behälters und in der den Behälter umgebenden Kammer jeweils ein Unterdruck eingestellt werden, wobei beide Drücke unterschiedlich ausgeführt sein können. Wenn z.B. eine Außenbeschichtung am Behälter aufgebracht werden soll, ist der Unterdruck in der den Behälter umgebenden Kammer so einzustellen, dass ein Beschichtungsvorgang stattfinden kann, dass also z.B. ein Plasma entstehen kann, während der Druck im Behälterinneren so einzustellen ist, dass bei Einstellen des Unterdrucks in der umgebenden Kammer der Behälter aufgrund eines Druckunterschiedes innen zu außen nicht beschädigt wird. Es ist mitunter durchaus gewünscht, dass der Druck im Inneren abweicht vom Außendruck, damit im Inneren zuverlässig kein Plasma entstehen kann. Soll hingegen das Behälterinnere beschichtet werden, so ist im Behälterinneren ein Unterdruck einzustellen, der einen solchen Beschichtungsvorgang ermöglicht, also z.B. das Ausbilden eines Plasmas, während der Druck in der umgebenden Kammer so einzustellen ist, dass der Unterdruck im Behälterinneren den Behälter nicht beschädigt. Auch dies ist im Stand der Technik vielfältig bekannt, z.B. aus der EP 1 954 851 B1, der EP 1 773 512 B1, der WO03/100125 A1, der WO03/100121 A2 oder der WO03/100120 A2. Dort ist anhand von Beispielen offenbart, wie das Einstellen der Unterdruckbedingungen erfolgen kann und wie Beschichtungen auf Behälter in plasmabasierten Prozessen abgeschieden werden. Auch das Bereitstellen und Zuführen benötigter Prozessgase ist in diesem Stand der Technik beschrieben.

Für möglichst kurze Prozesszeiten und somit für das Erreichen hoher Produktionsraten sowie für das Erreichen einer guten und gleichbleibenden Beschichtungsqualität sollen die gewünschten Unterdruckverhältnisse im Behälter und in der umgebenen Kammer einerseits immer gleichbleibend und andererseits möglichst schnell und effektiv erreicht werden. Der Wunsch und die Tendenz ist weiterhin, dass z.B. PET-Behälter mit immer dünneren Wandstärken verlangt sind, da PET als Ausgangsmaterial ein Kostenträger ist. Entsprechend reagieren die sehr dünnwandigen Behälter empfindlicher auf einen Druckunterschied zwischen dem Behälterinneren und der umgebenden Kammer. Die schnelle und zugleich zuverlässige Einstellung der Unterdruckbedingungen ist somit von zunehmend hoher Wichtigkeit, um eine Beschädigung der Behälter zu vermeiden, um Prozesszeiten zu verkürzen, und um dennoch eine konstant gute Qualität der Beschichtung zu erzielen.

Ein in der Praxis häufiger Fall ist, dass ein Behälter mit einer Innenbeschichtung versehen werden soll, z.B. um Barriereeigenschaften des Behältermaterials zu verbessern, z.B. gegen Durchtritt von Sauerstoff nach innen oder von Kohlendioxid nach außen. Insofern wird im Rahmen der nachfolgenden Erläuterungen primär auf das Ausbilden von Innenbeschichtungen abgestellt, ohne dass aber damit eine Beschränkung des Gegenstandes der Erfindung beabsichtigt ist.

Im Falle einer Innenbeschichtung soll z.B. in der den Behälter umgebenden Kammer, also außen vom Behälter, sehr schnell ein Unterdruck von z.B. 45 mbar erreicht werden. Dieser Druck ist ausreichend, um bei üblichen Wandstärken den Behälter gegen Beschädigung zu schützen, wenn innerhalb des Behälters der für einen Beschichtungsvorgang notwendige Unterdruck eingestellt wird, der unterhalb dieser genannten 45 mbar liegt, z.B. bei oder unterhalb von 0,5 mbar. Die genannten Unterdruckwerte sind rein beispielhaft zu verstehen. Die benötigte Zeit für das Einstellen des äußeren Unterdruckes von z.B. 45 mbar soll möglichst gering sein. Eine Erhöhung der Pumpleistung durch Hinzunahme weiterer Pumpen führt in der Regel nicht zum Ziel, da zumeist der zur Verfügung stehende Pumpquerschnitt in den Pumpleitungen zur Kammer limitierend ist. Die Pumpdauer zu erhöhen widerspricht dem Wunsch nach einer hohen Durchsatzrate, also nach kurzen Prozesszeiten. Die bevorzugte Lösung wäre also, den Pumpquerschnitt größer zu machen.

Es ist im Stand der Technik bekannt, dass nicht nur eine Pumpstufe zur Verfügung steht, um die benötigten Unterdruckbedingungen einzustellen, sondern dass mehrere Pumpstufen bereitgestellt werden, und z.B. das Einstellen der Unterdruckbedingungen dadurch erfolgt, dass zeitlich nacheinander das Behälterinnere und/oder die umgebende Kammer mit einer oder mehreren dieser Pumpstufen verbunden wird. Bekannt ist zudem, dass pro Pumpstufe ein Ventil, ggf. auch mehrere Ventile, die entsprechende Pumpleitung beherrscht, wobei die Verbindung zum Behälterinneren und zur umgebenden Kammer gegebenenfalls und mit Vorteil von separaten Ventilen beherrscht wird, so dass wahl- und bedarfsweise beide Volumina gemeinsam oder getrennt abgepumpt werden können. Die umgebende Kammer und das Behälterinnere können dadurch unabhängig voneinander abgepumpt werden und unterschiedliche Drücke eingestellt werden. Das Vorsehen mehrerer Pumpstufen hat insbesondere Vorteile, wenn mehrere Beschichtungsstationen auf einem umlaufenden Beschichtungsrad angeordnet werden, da auf diese Weise unterschiedliche Beschichtungsstationen mit unterschiedlichen Pumpstufen verbunden werden können, ohne dass störende Wechselwirkungen eintreten. Sobald also für eine erste Station die erste Pumpstufe ihrer Aufgabe erfüllt hat, kann diese erste Station mit der zweiten Pumpstufe verbunden werden und die erste Stufe könnte mit einer nächsten Station verbunden werden und mit dem Abpumpen ausgehend von Umgebungsdruck beginnen. Das Vorsehen mehrerer Pumpstufen hat auch den Vorteil, dass in jeder Pumpstufe stufenspezifisch geeignete Pumpen vorgesehen sein können. Die erste Pumpstufe muss ausgehend vom Umgebungsdruck eine relativ große Gasmenge abführen. Die zweite und jede nachfolgende Pumpstufe kann dann ausgehend von dem in der vorhergehenden Pumpstufe erreichten Unterdruckniveau das Abpumpen fortsetzen, wobei geringere Gasmengen abzuführen sind, aber ausgehend von einem schon bestehenden Unterdruck gearbeitet wird. Es lassen sich also für diese unterschiedlichen Pumpbedingungen optimierte Pumpen einsetzen, und dies primär mit Blick auf kurze Prozesszeiten, hohe Standzeiten der Pumpen und Wirtschaftlichkeit bei den Kosten.

Grundsätzlich sind Beschichtungsstationen bekannt, die auch mehr als eine Beschichtungskammer aufweisen können. In solchen Mehrkammerstationen findet in allen Stationen simultan das Einstellen der Unterdruckbedingungen und das Durchführen eines Beschichtungsvorganges statt. Alle Stationen werden also zeitgleich mit der gleichen Pumpstufe verbunden, danach mit Prozessgasen für das Abscheiden einer Beschichtung versorgt und z.B. ein Plasma erzeugt. Ein weiteres Ziel bei solchen Mehrkammerstationen ist daher, dass in allen Kammern möglichst gleiche Unterdruckbedingungen eingestellt werden. Keine der Kammern soll gegenüber den anderen Kammern deutlich abweichende Unterdrücke aufweisen.

Die vorstehenden Erläuterungen zum Einstellen der Druckverhältnisse gelten nicht nur für das Abpumpen der entsprechenden Volumina, sondern auch für den umgekehrten Vorgang, nämlich für das Belüften dieser Volumina nach Beendigung eines Beschichtungsvorganges, also für das Abbauen des Unterdruckes bis auf einen Umgebungsdruck, damit im Anschluss ein fertig beschichteter Behälter aus einer Kammer entnommen und ein neuer Behälter in eine Kammer eingeführt werden kann. Auch dieses Belüften muss so erfolgen, dass zwischen dem Behälterinneren und der umgebenden Kammer keine so gro-ßen Druckunterschiede auftreten, dass der Behälter Schaden nimmt. In den Ansprüchen wird für beide Vorgänge, Abpumpen und Belüften, zusammenfassend von Betriebsmedien und von Betriebsmedienquellen gesprochen, wobei damit einerseits das Anschließen an eine Pumpstufe und andererseits das Anschließen an einen Umgebungsdruck gemeint ist, also das Belüfteten von zuvor auf einen Unterdruck gebrachter Volumina. Das von der Pumpstufe zugeführte Betriebsmedium wäre gewissermaßen ein Unterdruck, beim Belüfteten wird als Betriebsmedium ein Unterdruck abgebaut. In beiden Fällen kommt es zu Gasbewegung: beim Abpumpen mit den Pumpstufen wird Gas aus den abgepumpten Volumina herausgezogen, beim Belüfteten wird Gas in diese Volumina hineingeführt. Es liegt also jeweils ein gasförmiges Betriebsmedium vor.

Eine Aufgabe der vorliegenden Erfindung ist es Lösungen aufzuzeigen, wie die Unterdruckbedingungen schneller und zuverlässiger in der gewünschten Weise eingestellt werden können - sowohl beim Abpumpen als auch beim Belüften.

Gemäß einem ersten Aspekt wird diese genannte Aufgabe erfindungsgemäß gelöst durch eine Beschichtungsstation mit den Merkmalen von Anspruch 1. Diese Beschichtungsstation dient der Beschichtung von Werkstücken in einem auf der Beschichtungsstation ablaufenden Beschichtungsverfahren. Im Besonderen ist die Erfindung anwendungsgeeignet bei der Beschichtung von Innenwänden von Behältern, insbesondere von Flaschen, insbesondere mittels eines PECVD-Verfahrens, insbesondere mittels eines mikrowelleninduzierten PECVD-Verfahrens.

Wie auch schon zum Stand der Technik erläutert, weist die Beschichtungsstation wenigstens eine Beschichtungskammer auf, die in einen geöffneten und einen geschlossenen Zustand überführbar ist. Das Öffnen und Schließen der Kammer ist erforderlich, um ein Werkstück in der Kammer anzuordnen und nach erfolgter Beschichtung wieder zu entnehmen. Die Kammer ermöglicht das Einstellen von Unterdruckbedingungen, die ohne die Kammer nicht einstellbar wären, da das Werkstück den sich einstellenden Druckunterschied innen versus außen nicht aushalten würde. In der besagten Kammer ist also das zu beschichtende Werkstück anordenbar zum Zwecke der Beschichtung. Die Kammer ist von Kammerwänden gebildet. Dichteinrichtungen sind an den Kammerwänden vorgesehen, sodass die Kammer dadurch im geschlossenen Zustand abgedichtet gegen die Außenumgebung verschließbar ausgeführt ist. Das Abdichten stellt sicher, dass die erforderlichen Unterdruckbedingungen erreichbar sind und jedenfalls über die übliche Beschichtungsprozessdauer aufrechterhalten bleiben. In an sich bekannter Art und Weise ist für das Anordnen des Werkstückes in der Kammer ein Halte- und Dichtmittel angeordnet, welches ausgebildet ist, das Werkstück und das Werkstückinnere sowohl gegenüber der Umgebung als auch gegenüber der umgebenden Kammer abgedichtet innerhalb der Kammer zu halten. Die Beschichtungsstation weist einen oder mehrere Anschlüsse auf für den Anschluss an wenigstens eine Unterdruckquelle, z.B. an eine Vakuumpumpe oder an eine Gruppe von Vakuumpumpen, und/oder für den Anschluss an eine Druckausgleichsquelle, wobei das Anschließen an eine Druckausgleichsquelle z.B. das Herstellen einer Verbindung mit der Umgebung sein kann. Beide Quellen lassen sich als Betriebsmediumquelle für ein Betriebsmedium bezeichnen. Anders ausgedrückt besteht also die Möglichkeit, die Beschichtungsstation mit einer Vakuumpumpstufe zu verbinden und/oder mit der Umgebung zu verbinden -jeweils realisiert durch einen Anschluss. Für die Verbindung mit der Umgebung wäre eine schlichte Öffnung als Anschluss ausreichend.

Das Betriebsmedium und/oder alle Betriebsmedien werden innerhalb der Station von dem Anschluss aus über eine zugeordnete, am Anschluss beginnende Versorgungsleitung für das Betriebsmedium zu der Kammer und/oder zu dem Werkstück geführt, wobei die Versorgungsleitung dort ihr Leitungsende aufweist. Entsprechend hat die Versorgungsleitung im Bereich des Anschlusses ihren Leitungsanfang. Nicht ausgeschlossen ist, dass die Versorgungsleitungen teilweise zusammenfallen. Es sind Konstellationen denkbar, dass sie sogar vollständig zusammenfallen. So kann beispielsweise das Belüften erfolgen, indem die Belüftungsleitung teilweise oder vollständig mit einer Pumpleitung zusammenfällt, insbesondere ihre Leitungsenden zusammenfallen.

Soweit entspricht die beschriebene Beschichtungsstation einer aus dem Stand der Technik bekannten Beschichtungsstation.

Nach der Erfindung soll sich die Versorgungsleitung an wenigstens einer Zweigstelle, die zwischen ihrem Leitungsanfang und ihrem Leitungsende angeordnet ist, in Teilleitungen aufteilen, wobei in jeder Teilleitung ein schaltbares Ventil angeordnet ist. Es ergeben sich daraus vorteilhafte Realisierungsmöglichkeiten und je nach Anwendung dieser kennzeichnenden Merkmale ergeben sich unterschiedliche Vorteile, die nachfolgend beschrieben werden.

Es ist grundsätzlich möglich, bei einer Beschichtungsstation die Zeitdauer für das Einstellen der Unterdruckbedingungen durch Vorsehen eines vergrößerten Pumpquerschnittes zu verkürzen. Die zum abzupumpenden Volumen führende Leitung könnte im Querschnitt einfach vergrößert werden. In analoger Weise könnte der Querschnitt einer Belüftungsleitung vergrößert werden, sodass in kürzerer Zeit die für den Belüftungsvorgang benötigte Belüftungsgasmenge durch die Leitung strömen könnte. Dem vergrößerten Pumpquerschnitt bzw. Belüftungsquerschnitt entsprechend wäre ein ebenfalls größeres Ventil vorzusehen, das die querschnittsvergrößerte Leitung beherrscht. Dies bedeutet in der Regel dann aber auch, dass ein trägeres und somit mit höheren Schaltzeiten verbundenes Ventil zu verwenden ist. Weiterhin bedeutet dies, dass zu bereits vorhandenen, bewährten und optimierten Ventilen, nämlich zu denen in den Leitungen bisheriger Querschnittsgröße, ein weiteres Ventil anderer Bauart und Größe hinzuträte. Es besteht aber der Wunsch, vorhandene und bewährte Ventile für möglichst viele, vielleicht sogar für alle Anwendungen einsetzen zu können, um die Zahl der Ventile unterschiedlicher Bauart gering zu halten.

Erfindungsgemäß, nämlich gemäß Anspruch 2, der einen ersten Aspekt der Erfindung betrifft, ist daher statt einer querschnittsvergrößerten und von einem vergrößerten Ventil beherrschten Leitung vorgesehen, dass die Versorgungsleitung wenigstens einer Zweigstelle aufweist, die zwischen ihrem Leitungsanfang und ihrem Leitungsende angeordnet ist, und sich die Versorgungsleitung an dieser Zweigstelle in Teilleitungen aufteilt, wobei in jeder Teilleitung ein schaltbares Ventil angeordnet ist, wobei zudem die Teilleitungen im gleichen Volumen münden, das mit dem darin geführten Betriebsmedium versorgt werden soll, sprich das Volumen soll abgepumpt oder belüftet werden. Auf diese Weise lässt sich ein vergrößerter Strömungsquerschnitt erreichen, da nunmehr mehrere parallele Leitungsquerschnitte, nämlich die Querschnitte der Teilleitungen, gemeinsam genutzt werden können zur Führung des Betriebsmediums. Die Versorgungsleitung sollte bis zur Zweigstelle entsprechend einen Querschnitt aufweisen, der der Summe der Querschnitte der Teilleitungen entspricht oder der größer ist. Nur dann lässt sich die Summe der Querschnitte der Teilleitungen, mithin der zur Verfügung stehende Querschnitt, voll ausnutzen. Anderenfalls würde der Querschnitt der Versorgungsleitung bis zur Zweigstelle limitierend wirken. Da gemäß der Erfindung in den Teilleitungen ein schaltbares Ventil angeordnet ist, kann dieses Ventil kleiner ausgeführt sein als säße das Ventil in der Versorgungsleitung. Es steht frei, auch in der Versorgungsleitung, nämlich leitungsanfangsseitig vor der Zweigstelle, ein schaltbares Ventil anzuordnen, notwendig ist dies aber nicht, häufig wird dies sogar unnötig und überflüssig sein.

Das Vorsehen mehrerer Ventile in den Teilleitungen statt eines großen Ventiles in der Versorgungsleitung hat zudem den Vorteil, dass eine kompaktere Anordnung der Ventile möglich ist und größere Freiheitsgrade bei der Unterbringung der Ventile bestehen. Zumindest theoretisch ergibt sich auch ein Zeitvorteil aufgrund kürzerer Schaltzeiten. Dieser Zeitvorteil tritt zu dem Vorteil hinzu, der durch den in Summe vergrößerten Querschnitt erreicht wird, nämlich, dass ein Abpumpvorgang oder ein Belüftungsvorgang schneller ablaufen kann.

Das Vorsehen mehrerer Teilleitungen, die alle in ein gemeinsames Volumen einmünden, ist nicht nur vorteilhaft bezüglich eines Belüftens des Volumens und bezüglich einer Druckabsenkung ausgehend vom Umgebungsdruck durch Anschließen an eine erste Pumpstufe, sondern grundsätzlich auch vorteilhaft für weitere Pumpstufen. Allerdings ergibt sich ein besonderer Zeitvorteil bei der ersten Druckstufe und beim Belüften, und zudem ist bei dieser ersten Druckstufe und dem Belüften die Gefahr für eine zu starke Belastung des Werkstückes aufgrund zu großer Druckunterschiede innen und außen am Größten. Für spätere Druckstufen hat sich bislang der Leitungsquerschnitt noch nicht als limitierender Faktor gezeigt.

Nach einem zweiten Aspekt der Erfindung, nämlich gemäß Anspruch 3, insbesondere gemäß Anspruch 4, rückt die Gleichmäßigkeit der Beaufschlagung mit einem Betriebsmedium in den Blickpunkt. Dem Erreichen dieser Gleichmäßigkeit dient das in Anspruch 3 angesprochene Merkmal, dass Länge und Durchmesser der Teilleitungen so gewählt sind, dass der Strömungswiderstand des Betriebsmediums durch jede Teilleitung gleich ist. Dies umfasst einerseits die Möglichkeit, dass die Teilleitungen eine identische Länge und einen identischen Durchmesser haben, sodass deswegen auch der Strömungswiderstand identisch ist. Möglich ist aber auch, dass z.B. eine der Teilleitungen eine abweichende Länge hat und diese abweichende Länge durch einen abweichenden Durchmesser mit Blick auf den sich aus den beiden Faktoren ergebenden Strömungswiderstand kompensiert wird. Ist z.B. eine der Teilleitungen länger als eine andere Teilleitung, so wäre der Strömungswiderstand bei identischem Durchmesser vergrößert. Also müsste zur Erreichung eines gleichen Strömungswiderstandes bei der längeren Teilleitung ein größerer Querschnitt gewählt werden. Bevorzugt ist aber, dass die Teilleitungen bezüglich Länge und Durchmesser identisch ausgeführt sind, weil dies als die einfachste technische Umsetzung für das Erreichen gleicher Strömungswiderstände betrachtet wird. Wenn die Leitungen und Teilleitungen z.B. als Bohrungen in einem Leitungsblock ausgeführt sind, liegen bezüglich der Herstellung einfache Verhältnisse vor.

Der Vorteil von Teilleitungen mit jeweils untereinander gleichem Strömungswiderstand ist besonders ausgeprägt, wenn eine Beschichtungsstation mehrere gleiche Beschichtungskammern aufweist, in denen simultan jeweils Unterdruckbedingungen einzustellen sind, danach Beschichtungsprozesse ablaufen und anschließend ein Belüften erfolgen muss. In einem solchen Fall ergeben sich Vorteile, wenn zu jeder dieser mehreren Beschichtungskammern eine der besagten Teilleitungen führt und jede dieser Teilleitungen einen gleichen Strömungswiderstand für das Betriebsmedium aufweist. Die einfachste Realisierung eines gleichen Strömungswiderstandes gelingt erneut, indem alle Teilleitungen die gleiche Länge und den gleichen Durchmesser aufweisen. Die gleiche Länge ist z.B. erreichbar, indem die Anordnung der Zweigstelle und die Anordnung der von der Zweigstelle abgehenden Teilleitungen relativ zu den Kammern bzw. Werkstücken bestimmte Symmetriebedingungen erfüllen, die beispielhaft später in der Figurenbeschreibung anhand von Ausführungsbeispielen erläutert werden. Eine solche symmetrische Anordnung ist auch in der Herstellung vorteilhaft. Der zweite Aspekt der Erfindung betrifft also in einer Ausprägung die Symmetrie der Anordnung der Versorgungsleitungen und von deren Teilleitungen zu den äußeren Kammern, aber auch die Symmetrie der Anordnung der Belüftungsleitungen zu den Kammern. Durch diese Symmetrie bzw. verallgemeinert gesprochen durch das Vorsehen gleicher Strömungswiderstände in den Teilleitungen, gelingt mit Vorteil, dass der Druck während des Evakuierens oder des Belüftens der Kammern bzw. der Werkstücke (z.B. Behälter, z.B. Flaschen) in allen Kammern bzw. Behältern in gleichlaufender Weise absinkt bzw. ansteigt. Dies ist zunehmend wichtig, da die Wandstärken von Behältern bzw. Flaschen tendenziell immer geringer werden sollen, Stichwort Lightweight-Flaschen. Dünnwandige Flaschen sind aber nur noch in der Lage, geringe Druckdifferenzen zwischen innen und außen auszuhalten.

Die Erfindung führt bei beiden genannten Aspekten dazu, dass mehrere gleiche, kleinere Ventile anstelle eines großen Ventils vorgesehen werden. Dadurch ist es einfacher, ein symmetrisches System der Zufuhr der Betriebsmedien aufzubauen. Durch eine erhöhte Symmetrie fallen Effekte, die durch kurze Prozesszeiten (-150ms) entstehen können, geringer aus oder entfallen vollständig. Durch den Einsatz kleinerer, schon bekannter und an weiteren Orten des Systems eingesetzter Ventile im gleichen Format können Kostenvorteile im Vergleich zu individuell zugeschnittenen Systemen in jeweils kleinen Mengen erzielt werden. Zudem ist die Austauschbarkeit leichter gegeben.

Das Vorsehen einer größeren Anzahl an Ventilen führt zunächst dazu, dass mehr Ventile zu schalten sind und also der Steuerungsaufwand zunächst größer erscheint. Allerdings können Ventile mit Vorteil in der Steuerung logisch verknüpft und somit virtuell zu einem Ventil zusammengefasst werden. So ist es beispielsweise möglich, alle Ventile in den Teilleitungen oder Gruppen von diesen Ventilen, z.B. Ventilpaare, virtuell wie ein Ventil zu behandeln und mit einem Schaltbefehl gleichzeitig zu öffnen oder zu schließen. Je nach Anwendungsfall kann natürlich dennoch eine Einzelschaltung vorgesehen sein und vorgenommen werden, z.B. weil eine oder mehrere Kammern der Mehrkammerstation nicht beaufschlagt werden sollen, z.B. in einem Einrichtbetrieb oder falls es in einer der Kammern zu einer Störung kommt.

Es kann vorteilhaft sein, dass die Teilleitungen alle untereinander durch Querleitungen verbunden sind. Etwaige noch vorhandene Unterschiede im Leitungsverhalten der Teilleitungen lassen sich dadurch weiter ausgleichen, z.B. in Fällen, in denen diese Unterschiede entstehen, weil sich Teilleitungen in unterschiedlicher Weise über die Zeit zusetzen. Es lässt sich dadurch im Bedarfsfall auch ausgleichen, wenn z.B. eines der Ventile in den Teilleitungen unvollständig oder gar nicht mehr öffnet, wobei hierfür die besagte Querleitung im Bereich zwischen den Ventilen und den Mündungen der Teilleitungen an diesen anzuschließen ist.

In Bezug auf die schaltbaren Ventile können diese z.B. als Magnetventil ausgeführt sein, also bei Strombeaufschlagung der Ventile eine Magnetkraft das Ventil öffnen oder schlie-ßen. Gedacht ist auch an pneumatisch oder hydraulisch arbeitende Ventile, die z.B. Pilotventile aufweisen, welche wiederum als Magnetventil ausgeführt sind. Der Begriff des schaltbaren Ventils meint generell, dass eine Steuerung das Ventil aus einer Offen- in eine Geschlossenstellung und umgekehrt überführen kann. Damit ist nicht ausgeschlossen, dass auch Zwischenstellungen eingenommen werden können. Primär geht es aber um das von einer Steuerung ausgelöste Öffnen und Schließen der Ventile.

Es sind im Stand der Technik insbesondere auch Beschichtungsstationen mit vier Kammern bekannt. Bei einer solchen Vier-Kammer-Station bietet sich das Aufteilen einer Versorgungsleitung an einer ersten Zweigstelle (Zweigstelle 1. Ordnung) in zwei Teilleitungen an, sowie eine weitere Aufteilung der Teilleitungen an Zweigstellen 2. Ordnung in insgesamt vier Unterteilleitungen an. Dies wird als vorzugswürdig angesehen gegenüber einer Lösung, ausgehend von einer Versorgungsleitung nur eine Zweigstelle vorzusehen, von welcher sich dann vier Teilleitungen zu den Kammern erstrecken. In diesem speziellen Fall einer Vier-Kammer-Station könnte z.B. in den beiden Teilleitungen zwischen Zweigstelle 1. Ordnung und den Zweigstellen 2. Ordnung jeweils ein schaltbares Ventil angeordnet werden. Dies erscheint vorzugswürdig gegenüber einer Lösung, vier Ventile in den vier Unterteilleitungen anzuordnen, ohne dass dies aber grundsätzlich ausgeschlossen ist. Ausgeschlossen ist nach Anspruch 1 aber, dass weder in den beiden Teilleitungen noch in den vier Unterteilleitungen ein Ventil angeordnet ist, sondern z.B. nur in der Versorgungsleitung.

Das Aufspalten der Leitungen an den Zweigstellen in jeweils zwei Unterleitungen wird generell als vorteilhaft betrachtet gegenüber Alternativen, mehr als zwei Unterleitungen vorzusehen. Es sind dann also bevorzugt z.B. bei Beschichtungsstationen mit 2" Kammern, mit n als natürlicher Zahl größer oder gleich 1, Zweigstellen bis hin zur n. Ordnung vorgesehen. Eine Beschichtungsstation mit acht Kammern hätte also eine Zweigstelle 1. Ordnung, zwei Zweigstellen 2. Ordnung und vier Zweigstellen 3. Ordnung.

Besonders hohe Produktionsleistungen sind erreichbar mit Maschinen rotierender Bauart, sodass für solche Maschinen ein besonderes Bedürfnis für kurze Prozesszeiten gegeben ist. Die vorstehenden Ausführungen sind also besonders zutreffend bei solchen Maschinen rotierender Bauart. Insofern ist eine bevorzugte Ausführungsform der Erfindung, dass eine Beschichtungsstation, weiter bevorzugt mehrere Beschichtungsstationen, wie zuvor in verschiedenen Varianten beschrieben, auf einem Beschichtungsrad angeordnet ist, das zu einem kontinuierlich drehenden Umlauf antreibbar ausgebildet und angeordnet ist. Dies beschreibt ein übliches Arbeitsrad, auf dem während eines kontinuierlichen Umlaufs in einer oder mehreren Arbeitsstationen ein Behandlungsschritt ausgeführt wird. Die anspruchsgemäße Zweigstelle soll dabei in einem mit dem Beschichtungsrad umlaufenden Bereich angeordnet sein, wobei insbesondere mehrere solcher Beschichtungsstationen auf dem Beschichtungsrad angeordnet sind, bevorzugt in äquidistant umfangsverteilter Art.

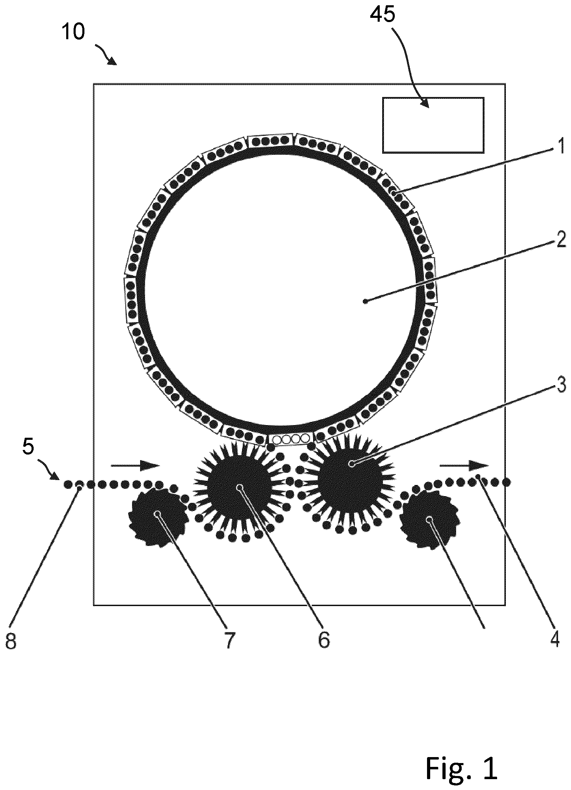

Nachfolgend wird die Erfindung anhand von bevorzugten Ausführungsbeispielen und anhand der beiliegenden Figuren näher erläutert. Die Zeichnungen sind nicht unbedingt maßstabsgetreu. In den Figuren sind gleiche oder im Wesentlichen funktionsgleiche bzw. - ähnliche Elemente mit den gleichen Bezugszeichen bezeichnet. Ohne Beschränkung der Allgemeinheit sind Behälter ein typischer Anwendungsfall eines Werkstücks. Insofern wird bei der nachfolgenden Beschreibung konkreter Ausführungsbeispiele nur noch von Behältern gesprochen. Weiterhin wird nachfolgend zur Erläuterung der Erfindung insbesondere und ebenfalls ohne Beschränkung der Allgemeinheit auf Behälter aus einem thermoplastischen Kunststoff, eingegangen, insbesondere auf Behälter aus PET, und insbesondere wird eine Innenbeschichtung solcher Behälter beschrieben. Es zeigen:
- Fig. 1: eine schematische Aufsicht auf eine Beschichtungsanlage, wie sie im Grundaufbau und grundsätzlich im Stand der Technik bekannt ist;
- Fig. 2: eine perspektivische Ansicht auf ein erstes Beispiel für eine vereinzelte Beschichtungsstation;
- Fig. 3: eine Schnittansicht durch ein zweites Beispiel für eine vereinzelte Beschichtungsstation mit Doppelkammer;
- Fig. 4: eine schematische Schnittansicht zu einem erfindungsgemäßen Ausführungsbeispiel;
- Fig. 5: eine schematische Schnittansicht zu einem weiteren erfindungsgemäßen Ausführungsbeispiel;
- Fig. 6: eine Prinzipdarstellung zu einem weiteren erfindungsgemäßen Ausführungsbeispiel; und
- Fig. 7: Prinzipdarstellungen zu zwei weiteren erfindungsgemäßen Ausführungsbeispielen.
Aus der Darstellung in Fig. 1 ist eine Beschichtungsanlage, genauer gesagt eine PECVD-Anlage 10 zu erkennen, die mit einem rotierenden Beschichtungsrad 2 versehen ist. Entlang eines Umfanges des Beschichtungsrades 2 sind umfangsbeabstandet eine Mehrzahl von Beschichtungsstationen 1 angeordnet. Da plasmabasierte Beschichtungsvorgänge stattfinden, wird nachfolgend auch von einem Plasmarad 1, Plasmastationen 1 und Plasmakammern 17 gesprochen. In synonymer Weise könnte auch von Beschichtungsrad 2, Beschichtungskammern 17 und Beschichtungsstationen 1 gesprochen werden.

Die Plasmastationen 1 sind mit später noch gezeigten Kavitäten bzw. Plasmakammern 17 zur Aufnahme von zu behandelnden Werkstücken 5 versehen. Beispielhaft ist gezeigt, dass jede Plasmastation 1 vier Behandlungsplätze aufweist. Diese PECVD-Anlage 10 steht rein exemplarisch für alle Beschichtungsanlagen, die unter Zuführung von Prozessgasen Beschichtungsprozesse ausführen. Weiterhin werden nachfolgend die Werkstücke lediglich beispielhaft von Behältern 5 gebildet.

Die zu behandelnden Behälter 5 werden dem Plasmarad 2 im Bereich einer Eingabe 8 zugeführt und über ein Vereinzelungsrad 7 an ein Übergaberad 6 weitergeleitet, das mit Tragarmen ausgestattet ist, die z.B. positionierbar ausgeführt sein können. Die Tragarme können z.B. relativ zu einem Sockel des Übergaberades 6 verschwenkbar angeordnet sein, so daß eine Abstandsveränderung der Behälter 5 relativ zueinander durchgeführt werden kann. Hierdurch erfolgt eine Übergabe der Behälter 5 vom Übergaberad 6 an das Plasmarad 2. Nach einer Durchführung der Behandlung während des Umlaufes auf dem Plasmarad 2 werden die behandelten Behälter 5 von einem Ausgaberad 3 aus dem Bereich des Plasmarades 2 entfernt und in den Bereich einer Ausgabestrecke 4 überführt.

Es sind im Stand der Technik die beiden Möglichkeiten bekannt, die z.B. als Behälter ausgebildeten Werkstücke 5 mit Mündungsbereich nach oben oder nach unten weisend zu beschichten. Da der Transport der Behälter 5 einfacher ist, wenn der Mündungsbereich nach oben weist, könnte z.B. die Zuführung der Behälter 5 im Bereich der Eingabe 8 mit Mündungsbereich nach oben weisend erfolgen und z.B. auf dem Übergaberad 6 der Behälter 5 gewendet werden in eine Positionierung mit Mündungsbereich nach unten. Arbeitsräder mit einer solchen Wendefunktion sind im Stand der Technik bekannt. In dieser Positionierung würde die Übergabe der Behälter 5 auf das Plasmarad 2 erfolgen und auch die Entnahme vom Plasmarad 2 nach erfolgter Behandlung. Das Ausgaberad 3 könnte dann erneut ein Wenden des Behälters 5 vornehmen und der Behälter 5 anschließend mit einer Positionierung mit Mündung nach oben der Ausgabestrecke 4 zugeführt werden. Ohne Beschränkung der Allgemeinheit wird in nachfolgenden Abbildungen eine Positionierung des Behälters 5 mit Mündungsbereich nach unten weisend gezeigt. Möglich ist natürlich auch, dass die Behandlung auf dem Plasmarad 2 mit Mündungsbereich nach oben weisend erfolgt und kein Wendevorgang vor und nach dem Plasmarad 2 ausgeführt wird.

In nicht dargestellter Weise, weil im Stand der Technik hinreichend bekannt, werden den mit dem Plasmarad 2 umlaufenden Plasmastationen 1 die für den Beschichtungsprozess notwendigen Prozessgase zugeführt. Die auf das Plasmarad 2 übergebenen Prozessgase liegen bei der Übergabe in der erforderlichen Zusammensetzung vor und werden von einer außerhalb des Plasmarades 2 angeordneten Gasversorgungsvorrichtung bereitgestellt, die nicht weiter beschrieben wird, da diese für den Gegenstand der Erfindung nicht von Bedeutung ist. Die Zuführung erfolgt in der Regel in einem Zentrum des Plasmarades 2 und über einen dort angeordneten Drehverteiler, über den die Plasmastationen 1 auch mit Betriebsmitteln sowie Energie versorgt werden. Zur Prozessgas- und zur Betriebsmittelverteilung werden insbesondere Ringleitungen eingesetzt.

Bei der vorliegenden Erfindung werden die Prozessgase nicht unter den Begriff "Betriebsmittel" gefasst. Der Begriff "Betriebsmittel" bezieht sich im Rahmen der vorliegenden Erfindung nur auf einen Unterdruck, erzeugt von einer Unterdruckquelle als Betriebsmittelquelle, sowie auf eine Druckausgleichquelle als Betriebsmittelquelle, die einen Unterdruck beseitigt.

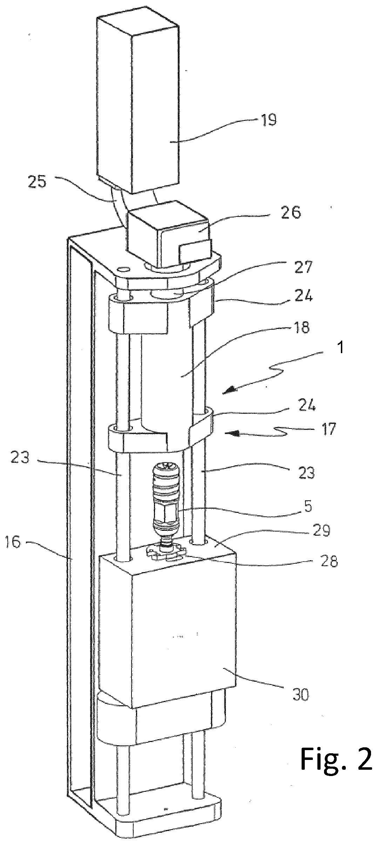

In Fig. 2 ist zur Erläuterung eines möglichen grundsätzlichen Aufbaus einer Plasmastation 1 in perspektivischer Darstellung eine Station mit einem Einzelbehandlungsplatz gezeigt. Ein Stationsrahmen 16 ist mit Führungsstangen 23 versehen, auf denen ein Schlitten 24 zur Halterung der zylinderförmigen Kammerwandung 18 geführt ist. Fig. 2 zeigt den Schlitten 24 mit Kammerwandung 18 in einem angehobenen Zustand, so daß das auf dem Kopf stehende Werkstück in Form eines Behälters 5 freigegeben ist. Im angehobenen Zustand der Kammerwandung 18 befindet sich die Plasmakammer 17 in einer Offenstellung, im abgesenkten Zustand der Kammerwandung 18 befindet sich die Plasmakammer 17 in einer Geschlossenstellung.

Im oberen Bereich der Plasmastation 1 ist ein Mikrowellengenerator 19 angeordnet. Der Mikrowellengenerator 19 ist über eine Umlenkung 25 und einen Adapter 26 an einen Kopplungskanal 27 angeschlossen, der in die Plasmakammer 17 einmündet. Der Adapter 26 hat die Funktion eines Übergangselementes. Die Umlenkung 25 ist als ein Hohlleiter ausgebildet. Der Behälter 5 wird im Bereich eines zangenartigen Halte- und Dichtelementes 28 positioniert, das im Bereich eines Kammerbodens 29 angeordnet ist, und das z.B. wie in der DE 10 2022 119 836 beschrieben ausgeführt sein kann. Der Kammerboden 29 ist als Teil eines Kammersockels 30 ausgebildet.

Zum Schließen der Plasmakammer 17 kann der Schlitten 24 mit der zylinderförmigen Kammerwandung 18 entlang der Schienen 23 abgesenkt werden, bis die Kammerwandung 18 gegen den Kammerboden 29 gefahren ist. In diesem geschlossenen Positionierzustand kann die Plasmabeschichtung des dann in der geschlossenen Kavität 17 eingeschlossenen Behälters 5 durchgeführt werden. Im geschlossenen Positionierzustand erfolgt auch das Einstellen des in der Kammer 17 und des im Behälter 5 erforderlichen Unterdruckes, um ein Plasma zu erzeugen und mikrowelleninduziert die Plasmabeschichtung vorzunehmen. Im geschlossenen Positionierzustand erfolgt auch ein Belüfteten der Kammer 17 und des in der Kammer 17 aufgenommene Behälters 5 auf einen Umgebungsdruck, damit die Kammer 17 geöffnet werden kann.

In der in Fig. 2 gezeigten angehobenen Positionierung der Kammerwandung 18 ist es ohne Probleme möglich, den behandelten Behälter 5 aus dem Bereich der Plasmastation 1 zu entfernen und einen neuen zu behandelnden Behälter 5 einzusetzen, z.B. mittels der in Figur 1 gezeigten Räder 6 und 3.

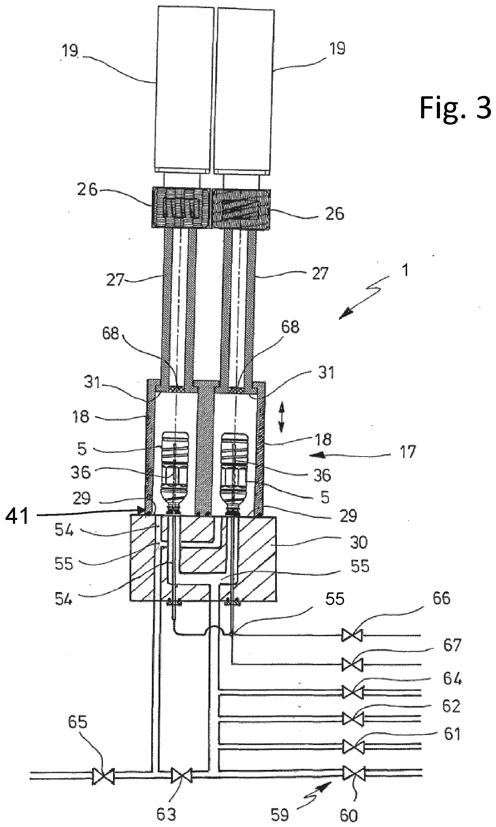

Fig. 3 zeigt ein alternatives Beispiel für eine Plasmastation 1 mit zwei Plasmakammern 17 zur gleichzeitigen Plasmabehandlung von zwei Behältern 5. Jede der Plasmakammern 17 ist über einen Kopplungskanal 27 sowie einen Adapter 26 und eine Umlenkung 25 an jeweils einen Mikrowellengenerator 19 angeschlossen. Grundsätzlich ist es ebenfalls denkbar, für zwei oder mehr Plasmakammern 17 einen gemeinsamen Mikrowellengenerator 19 zu verwenden und über eine nicht dargestellte Verzweigung eine Aufteilung der generierten Mikrowellenstrahlung vorzunehmen, um eine gleichmäßige Zündung des Plasmas in jeder der Plasmakammern 17 zu gewährleisten.

In die Plasmakammern 17 münden Versorgungskanäle 54 ein, die jeweils an eine Verzweigung 55 zur Aufteilung einer Menge eines zugeführten Betriebsmittels in zwei Teilmengen angeschlossen sind. Bei einer Verwendung von mehr als zwei Plasmakammern 17 wird die Verzweigung 55 entweder mit einer entsprechenden Anzahl von Ausgängen versehen, oder es werden kaskadiert mehrere Teilverzweigungen hintereinander angeordnet. Über diese Kanäle 54, 55 kann z.B. Unterdruck zugeführt werden. Diese Kanäle 54, 55 sind Beispiele für Versorgungsleitungen im Sinne der Patentansprüche.

Zusätzlich eingezeichnet ist eine Gaslanze 36, die in vertikaler Richtung in den Behälter 5 hineingefahren und herausgeführt werden kann, z.B. in nicht dargestellter Weise durch Anordnung an einem Lanzenschlitten, der in vertikaler Richtung geführt und z.B. kurvengesteuert eine Vertikalbewegung ausführen kann. In der dargestellten Positionierung ist die Plasmakammer 17 geschlossen und die Lanze 36 innerhalb des Behälters 5 angeordnet für das Austragen der Prozessgase in den Innenraum des Behälters 5.

Im Bereich des Kammersockels 30 erfolgt über die schon angesprochenen Kanäle 54, 55 die Beaufschlagung der Plasmakammern 17 und der Behälter 5 mit Unterdruck, auch ein Belüften ist möglich. Prozessgase werden über eine Leitung 66 der Gaslanze 36 zugeführt und in das Behälterinnere geleitet. Die Zuführung erfolgt jeweils ventilgesteuert. Die Leitung 66 steht in Verbindung mit einer nicht dargestellten Gasversorgungsvorrichtung und führt die von dieser Gasversorgungsvorrichtung bereitgestellten Prozessgase zur Gaslanze 36.

Fig. 3 zeigt in einer stark schematisierten Darstellung sowie mit zusätzlicher Darstellung von Ventilen 59 die Steuerung einer Betriebsmittelzufuhr und der Prozessgaszufuhr. Beim dargestellten Ausführungsbeispiel sind aufgrund der schaltungstechnischen Anordnung der Kopplungskanäle 54 drei Verzweigungen 55 verwendet. Zu erkennen sind ebenfalls Quarzglasfenster 68 zur Abdichtung der Innenräume der Plasmakammern 17 relativ zu den Innenräumen der Kopplungskanäle 27 bei gleichzeitiger Durchtrittsmöglichkeit für die Mikrowellenstrahlung.

Gemäß der gezeigten, rein beispielhaften Ausführungsform werden ein Primärvakuumventil 60 zur Zuführung einer ersten Unterdruckstufe sowie ein Sekundärvakuumventil 61 zur Zuführung eines gegenüber der ersten Unterdruckstufe niedrigeren Unterdruckes verwendet. Das Hinzutreten weiterer Unterdruckstufen ist möglich. Zur Aufrechterhaltung des Vakuums synchron zur Zuführung des Prozessgases ist darüber hinaus ein Prozessvakuumventil 62 angeordnet. Das Prozessvakuumventil 62 vermeidet einen Übertritt von abgesaugtem Prozessgas in die Versorgungskreise für das Primärvakuum und das Sekundärvakuum.

Zur Unterstützung einer wahlweisen oder gemeinsamen Zuführung von Unterdruck zum Innenraum des Behälters 5 und/oder in den weiteren Innenraum der Plasmakammer 17 ist ein Kammervakuumventil 63 verwendet, das eine entsprechende Absperrfunktion durchführt. Insbesondere ist daran gedacht, das jeweilige Versorgungsvakuum über die Ventile 60, 61, 62 jeweils unmittelbar dem Innenraum des Behälters 5 zuzuführen und über das Kammervakuumventil 63 gesteuert eine bedarfsabhängige Zuschaltung des weiteren Innenraumes der Plasmakammer 17 vorzunehmen.

Für eine vorgebbare und voneinander unabhängige Entlüftung sowohl des Innenraumes des Behälters 5 als auch des weiteren Innenraumes der Plasmakammer 17 wird ein Behälterentlüftungsventil 64 sowie ein Kammerentlüftungsventil 65 verwendet. Für eine Zuführung unterschiedlicher Prozessgaszusammensetzungen wird ein Primärprozessgasventil 66 sowie ein Sekundärprozessgasventil 67 verwendet. Denkbar ist auch das Zuführen weiterer Prozessgasmischungen, sodass weitere Leitungen und weitere Ventile hinzutreten könnten. Die Bereitstellung der Prozessgasmischungen erfolgt durch eine Gasversorgungsvorrichtung.

Ein typischer Behandlungsvorgang wird z.B. derart durchgeführt, daß zunächst der Behälter 5 wie zu Figur 1 erläutert zum Plasmarad 2 transportiert wird und das Einsetzen des Behälters 5 in die Plasmastation 1 in einem hochgeschobenen Zustand der hülsenartigen Kammerwandung 18 erfolgt. Nach einem Abschluss des Einsetzvorganges wird die Kammerwandung 18 in ihre abgedichtete Positionierung abgesenkt. Zum Zwecke der Abdichtung weist die Kammerwandung 18 stirnseitig umlaufende Dichtringe als Dichteinrichtung 41 auf. Zunächst wird gleichzeitig eine Evakuierung sowohl der Kavität 17 als auch eines Innenraumes des Behälters 5 durchgeführt, ggf. erfolgt zunächst auch nur eine Vorevakuierung der Kavität 17, bevor auch die Evakuierung des Innenraums des Behälters 5 zugeschaltet wird.

Nach einer ausreichenden Evakuierung des Innenraumes der Kavität 17 wird die Lanze 36 in den Innenraum des Behälters 5 eingefahren und eine Abschottung des Innenraumes des Behälters 5 gegenüber dem Innenraum der Kavität 17 durchgeführt. Ebenfalls ist es möglich, die Lanze 36 bereits synchron zur beginnenden Evakuierung des Innenraumes der Kavität 17 in den Behälter 5 hineinzuverfahren. Der Druck im Innenraum des Behälters 5 wird anschließend noch weiter abgesenkt. Darüber hinaus ist auch daran gedacht, die Positionierbewegung der Lanze 36 wenigstens teilweise bereits parallel zur Positionierung der Kammerwandung 18 durchzuführen. Nach Erreichen eines ausreichend tiefen Unterdruckes wird Prozessgas in den Innenraum des Behälters 5 eingeleitet und mit Hilfe des Mikrowellengenerators 19 das Plasma gezündet. Insbesondere ist daran gedacht, mit Hilfe des Plasmas sowohl einen Haftvermittler auf eine innere Oberfläche des Behälters 5 als auch die eigentliche Barriereschicht z.B. aus Siliziumoxiden abzuscheiden. Eine zusätzliche dritte Schicht, zum Beispiel eine Schutzschicht, könnte ebenfalls mit Hilfe des Plasmas abgeschieden werden, z.B. ebenfalls aus Siliziumoxiden.

Nach einem Abschluss des Beschichtungsvorganges wird die Lanze 36 wieder aus dem Innenraum des Behälters 5 entfernt und die Plasmakammer 17 sowie der Innenraum des Behälters 5 werden belüftet. Nach Erreichen des Umgebungsdruckes innerhalb der Kavität der Plasmakammer 17 wird die Kammerwandung 18 wieder angehoben, um eine Entnahme des beschichteten Behälters 5 sowie eine Eingabe eines neuen zu beschichtenden Behälters 5 durchzuführen. Das geschilderte Beschichtungsverfahren läuft ab, während der Behälter 5 in der Plasmastation 1 auf dem Plasmarad 2 umläuft.

Eine Positionierung der Kammerwandung 18 und/oder der Lanze 36 kann unter Verwendung unterschiedlicher Antriebsaggregate erfolgen. Grundsätzlich ist die Verwendung pneumatischer Antriebe und/oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades 2 eine Kurvensteuerung zu realisieren. Die Kurvensteuerung kann beispielsweise derart ausgeführt sein, daß entlang eines Umfanges des Plasmarades 2 Steuerkurven angeordnet sind, entlang derer Kurvenrollen geführt werden. Die Kurvenrollen sind mit den jeweils zu positionierenden Bauelementen gekoppelt.

Die Betätigung der Ventile 59 erfolgt vorzugsweise über eine programmierbare elektronische Steuerung 45. Zunächst wird nach einem Schließen der Plasmakammer 17 das Primärvakuumventil 60 geöffnet und der Innenraum des Behälters 5 und der Innenraum der Plasmakammer 17 gleichzeitig oder teilweise zeitlich versetzt evakuiert. Hierbei wird ein Druckniveau z.B. im Bereich von 20 mbar bis 50 mbar erreicht. Nach einem Schließen des Primärvakuumventils 60 erfolgt ein Öffnen des Sekundärvakuumventils 61 und der Innenraum des Behälters 5 und der Innenraum der Plasmakammer 17 werden zunächst gleichzeitig an eine Unterdruckquelle mit einem niedrigeren Druckniveau angeschlossen. Nach einer ausreichenden Evakuierung des den Behälter 5 umgebenden Innenraumes der Plasmakammer 17 schließt das Kammervakuumventil 63 und lediglich der Innenraum des Werkstückes 5 wird weiter evakuiert. Hierbei wird z.B. ein Druckniveau von etwa 0,1 mbar erreicht.

Nach einem Schließen des Kammervakuumventils 63 und einer in der Regel bereits zuvor erfolgten Positionierung der Lanze 36 innerhalb des Innenraumes des Behälters 5 öffnet das Primärprozessgasventil 66 und ein Prozessgas einer ersten Zusammensetzung wird zugeführt. Nach einer ausreichenden Prozessgaszuführung zündet der Mikrowellengenerator 19 das Plasma im Innenraum des Behälters 5. Zu einem vorgebbaren Zeitpunkt schließt das Primärprozessgasventil 66 und das Sekundärprozessgasventil 67 öffnet zur Zuführung eines Prozessgases einer zweiten Zusammensetzung. Zumindest zeitweise parallel zum Öffnen der Prozessgasventile 66, 67 öffnet auch das Prozessvakuumventil 62, um einen ausreichend niedrigen Unterdruck im Innenraum des Behälters 5 aufrecht zu erhalten. Hierbei erweist sich ein Druckniveau von z.B. etwa 0,3 mbar als zweckmäßig

Nach einem Abschluss der Plasmabeschichtung öffnet zunächst das Behälterentlüftungsventil 64 und schließt den Innenraum des Behälters 5 an einen Umgebungsdruck an. Mit einer vorgebbaren zeitlichen Verzögerung nach einem Öffnen des Behälterentlüftungsventils 64 öffnet auch das Kammerentlüftungsventil 65, um den Innenraum der Plasmakammer 17 wieder vollständig auf den Umgebungsdruck anzuheben. Nach einem zumindest annäherungsweisen Erreichen des Umgebungsdruckes innerhalb der Plasmakammer 17 kann die Plasmakammer 17 öffnen und der beschichtete Behälter 5 wird entnommen und durch einen neuen zu beschichtenden Behälter 5 ersetzt.

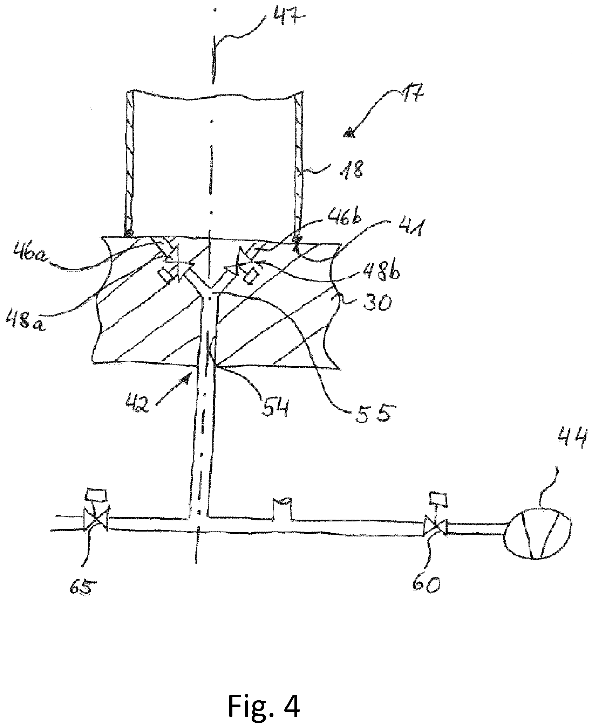

Die in Figur 4 dargestellte schematische Schnittansicht zeigt ein erfindungsgemäßes Ausführungsbeispiel anhand einer einzelnen Plasmakammer 17, zu der lediglich der untere Bereich der Kammerwandung 18 in ihrer geschlossenen Positionierung gezeigt ist, d. h. die kammerbodenzugewandte Dichteinrichtung 41 liegt abgedichtet am Kammersockel 30 an. Innerhalb dieses Kammersockels 30 verläuft eine Versorgungsleitung 54 ausgehend von einem Anschluss 42 hin zu der Kavität in der Plasmakammer 17. Zur zeichnerischen Vereinfachung ist kein in der Kammer angeordneter Behälter 5 gezeigt. Es ist auch nicht gezeigt, dass - wie noch in Figur 3 dargestellt - weitere Versorgungsleitungen innerhalb des Kammersockels 30 verlaufen. Im dargestellten Ausführungsbeispiel dient die Versorgungsleitung 54 der Verbindung der Kavität in der Plasmakammer 17 mit einer Vakuumpumpe 44, die im vorliegenden Beispiel der Primärpumpstufe aus Figur 3 entspricht. Demgemäß ist in der Pumpleitung, die zum Anschluss 42 der Versorgungsleitung 54 führt, das Primärvakuumventil 60 und ein Kammerentlüftungsventil 65 angeordnet.

In Übereinstimmung mit der Erfindung teilt sich die Versorgungsleitung 54 an einer Zweigstelle 55 in die beiden Teilleitungen 46a und 46b auf, welche jeweils von zugeordneten schaltbaren Ventilen 48a und 48b beherrscht sind. In nicht gezeigter Weise, sollen alle in Figur 4 dargestellten Ventile an einer Steuereinrichtung angeschlossen sein, welche diese Ventile mit Steuersignalen zum Öffnen oder Schließen versorgt. Diese Steuereinrichtung kann z.B. die in Figur 1 mit Bezugszeichen 45 genannte Steuerung sein. Denkbar ist auch, dass eine oder mehrere dezentrale Steuerungen vorgesehen sind, welche die Ventilsteuerung übernehmen. Eine solche Ventilsteuerung könnte z.B. im Bereich der Station (1) angeordnet sein.

In weiterer Übereinstimmung mit der Erfindung sind in den beiden Teilleitungen 46a und 46b jeweils Ventile 48a und 48b angeordnet, sodass diese Teilleitungen 46a, 46b grundsätzlich unabhängig voneinander geöffnet und geschlossen werden können. Es ist denkbar und bezüglich des Steueraufwandes mit einem Vorteil verbunden, die beiden Ventile 48a und 48b logisch zu verknüpfen und immer gemeinsam zu öffnen oder gemeinsam zu schließen. Denkbar ist auch, dass diese logische Verknüpfung in einem Produktionsbetriebsmodus besteht, dass diese logische Verknüpfung aber in einem anderen Modus nicht besteht. Denkbar ist z.B., dass z.B. in einem Fehlerfall eines der Ventile diese logische Verknüpfung aufgehoben wird, z.B. automatisch bei einem Entdecken eines Fehlers durch einen entsprechenden Sensor, der den Öffnungszustand eines Ventils überwacht, oder dass z.B. durch eine Bedienperson in der Steuerung die logische Verknüpfung aktiviert und/oder aufgehoben werden kann.

In weiterer Übereinstimmung mit einem vorteilhaften Aspekt der Erfindung sind die Versorgungsleitung 54 und die Teilleitungen 46a und 46b in symmetrischer Weise zur Stationsachse 47 angeordnet und ausgebildet. Die z.B. als zylindrische Bohrung im Kammersockel 30 ausgeführte Versorgungsleitung 54 ist z.B. so angeordnet, dass die Stationsachse 47 parallel zu der Leitungslängsachse 42 steht und die Teilleitungen 46a und 46b spiegelsymmetrisch zu beiden Seiten dieser Stationsachse 47 angeordnet sind. Die Spiegelebene steht dabei vertikal und die Stationsachse 47 liegt innerhalb dieser Spiegelebene.

Mit Vorteil und erfindungsgemäß ist vorgesehen, dass die Teilleitungen 46a und 46b eine gleiche Länge und einen gleichen Querschnitt aufweisen. Dies würde auch ohne die zu Fig. 4 dargestellte Symmetrie ausreichen, um diese beiden Teilleitungen 46a und 46b gleichwertig zu machen bezüglich des von der Vakuumpumpe 44 zur Verfügung gestellten Primärvakuums. Der Querschnitt der beiden parallel von der Zweigstelle 55 weggehenden Teilleitungen 46a und 46b summiert sich zu einem freien Pumpquerschnitt, der im gezeigten Ausführungsbeispiel zugleich auch dem freien Pumpquerschnitt der Versorgungsleitung 54 entsprechen soll.

Eine Abwandlung oder eine hinzutretende Ergänzung des in Figur 4 gezeigten Ausführungsbeispiels könnte so aussehen, dass die beiden Teilleitungen 46a und 46b nicht in der Kavität der Plasmakammer 17 münden, sondern in das Innere des in Figur 4 nicht dargestellten Behälters münden.

Die Versorgungsleitung 54 dient im gezeigten Ausführungsbeispiel nicht nur dazu, das von der Vakuumpumpe 44 bereitgestellte Primärvakuum zur Plasmakammer 17 zu führen, sondern auch das Entlüften der Plasmakammer 17 auszuführen. Zum Zwecke eines Entlüftens wäre das Primärvakuumventil 60 zu schließen und das Kammerentlüftungsventil 65 zu öffnen. Aufgrund der vorstehend schon erläuterten Symmetrie und aufgrund der sich daraus ergebenden gleichartigen Strömungseigenschaften der Teilleitungen 46a und 46b würde Belüftungsgas gleichberechtigt durch diese beiden Teilleitungen in die Plasmakammer 17 einströmen, bis sich ein Druckausgleich zwischen der Plasmakammer 17 und der kammerabgewandten Seite des Kammerentlüftungsventils 65 eingestellt hat, z.B. Umgebungsdruck.

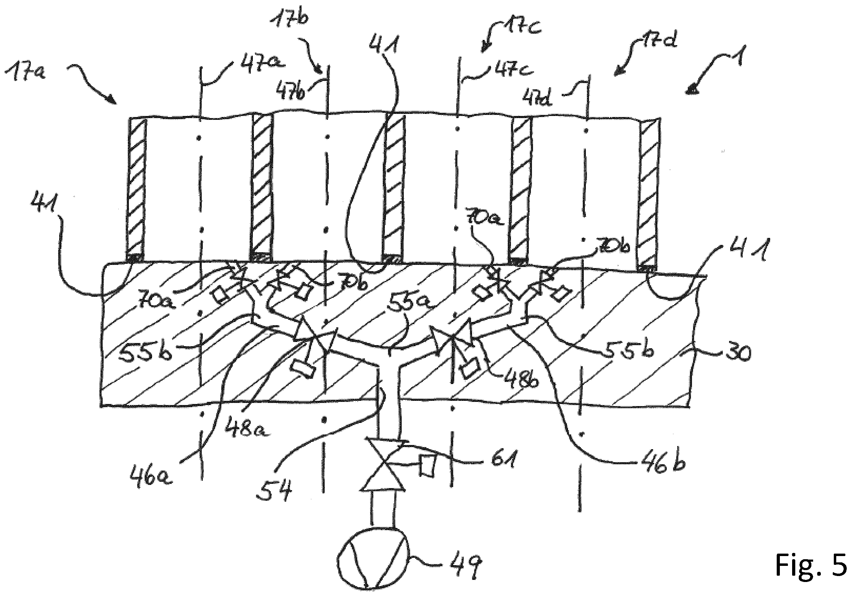

Figur 5 zeigt in einer ebenfalls schematischen Schnittansicht ein anderes erfindungsgemä-ßes Ausführungsbeispiel anhand einer Vier-Kammer-Plasmastation 1. Die Plasmastation 1 besteht also wie auch schon in Figur 1 dargestellt aus vier gleichberechtigten Plasmakammern 17a bis 17d mit vier Kammerachsen 47a bis 47d. Alle Plasmakammern 17a bis 17d sollen z.B. an eine Sekundärpumpstufe angeschlossen werden. Die Sekundärvakuumpumpe 49 ist daher über eine von Sekundärpumpventil 61 beherrschte Pumpleitung an eine Versorgungsleitung 54 im gemeinsamen Kammersockel 30 angeschlossen. Diese Versorgungsleitung 54 weist in Richtung der Kammern 17a bis 17d betrachtet eine erste Zweigstelle 55a auf und setzt sich hinter der Zweigstelle 55a als Teilleitungen 46a und 46b fort mit diese Teilleitungen beherrschenden Ventilen 48a und 48b. Im weiteren Verlauf hin zu den Plasmakammern 17a bis 17d münden diese beiden Teilleitungen 46a, 46b jeweils in Zweigstellen 55b 2. Ordnung, von denen jeweils zwei Unterteilleitungen 70a und 70b abzweigen, die jeweils in eine der vier Plasmakammern 17a bis 17d münden, und in denen jeweils schaltbare Ventile angeordnet sind, die in Figur 5 aus Gründen der Übersichtlichkeit ohne Bezugszeichen geblieben sind. Optional könnten die Ventile in den vier Unterteilleitungen 70a, 70b auch weggelassen sein und nur die Ventile 48a und 48b in den Teilleitungen 46a und 46b vorgesehen sein. Eine weitere Alternative könnte so aussehen, dass die Ventile in den vier Unterteilleitungen 70a, 70b vorgesehen sind, nicht aber die beiden Ventile 48a, 48b in den Teilleitungen 46a, 46b.

Die in Figur 5 für das Sekundärvakuum gezeigte Anordnung könnte in gleicher Weise für eine Primärvakuumstufe vorgesehen sein. Diese Anordnung könnte auch einer Belüftungsanordnung entsprechen.

Wie auch schon zur Figur 4 erläutert, soll der Strömungswiderstand ausgehend von der Sekundärvakuumpumpe 49 hin zu allen Plasmakammern 17a bis 17d gleich sein, damit die Pumpleistung auf alle Kammern gleichverteilt ist und in allen Kammern gleichlaufend ein Unterdruck ausgebildet wird. In dem in Figur 5 gezeigten Beispiel gelingt dies dadurch, dass die im Kammersockel 30 ausgeführten Leitungen symmetrisch zu einer Stationsachse angeordnet sind.

Auch zu dem Ausführungsbeispiel der Figur 5 könnte eine Abwandlung darin bestehen, dass die Unterteilleitungen 70a und 70b nicht in den Kavitäten der Plasmakammern 17a bis 17d münden, sondern in dort abgedichtet gehaltenen und angeordneten Behältern, welche in Figur 5 aus Gründen der zeichnerischen Vereinfachung nicht gezeigt sind. Denkbar ist auch, dass beide Varianten zusammen vorgesehen sind und über diese Leitungen auch ein Belüften der Plasmakammer und/oder der darin angeordneten Behälter erfolgt, ähnlich wie zu Fig. 4.

Die schematische Darstellung in Figur 5 deutet an, dass die Summe der Leitungsquerschnitte der vier gezeigten Unterteilleitungen 70a, 70b gleich der Summe der Querschnitte der Teilleitungen 46a, 46b ist und gleich dem Querschnitt der Versorgungsleitung 54.

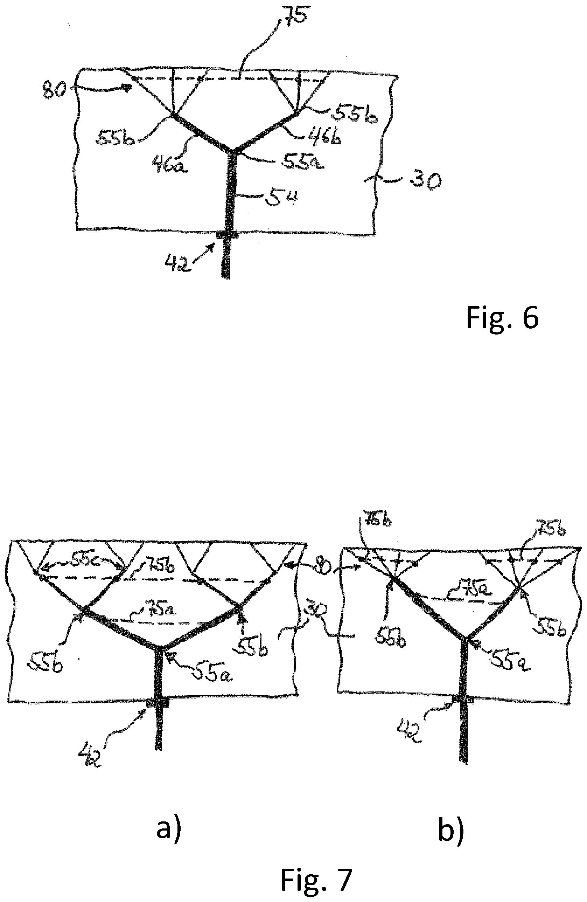

Figur 6 zeigt in einer reinen Prinzipdarstellung ein weiteres erfindungsgemäßes Ausführungsbeispiel, bei dem eine Plasmastation mit sechs Plasmakammern vorhanden sein soll, Kammerwände und in der Kammer angeordnete Behälter sind aus Übersichtsgründen nicht dargestellt. Gezeigt ist im Wesentlichen nur der Verlauf von Leitungen innerhalb eines Kammersockels 30. Die ursprüngliche Versorgungsleitung 54 soll sich an einer Zweigstelle 55a 1. Ordnung in zwei Teilleitungen 46a und 46b aufteilen, die bis zu zwei Zweigstellen 55b verlaufen und sich dort jeweils auf drei Unterteilleitungen aufteilen. Es liegen somit insgesamt sechs Unterteilleitungen 80 vor, über die die insgesamt sechs Plasmakammern mit einem Betriebsmedium versorgt werden können, also z.B. mit einer ersten Pumpstufe und/oder einer zweiten Pumpstufe und/oder mit einer Entlüftungsstufe verbunden werden können. Nicht dargestellt sind in Figur 6 Ventile, die diese Teilleitungen und/oder Unterteilleitungen beherrschen. Hierzu gilt z.B. das zu Figur 5 Gesagte.

Figur 6 zeigt weiterhin, dass eine (mit gestrichelter Linie dargestellte) Querleitung 75 alle Unterteilleitungen 80 miteinander verbindet, sodass die Unterteilleitungen 80 untereinander in Kommunikationsverbindung stehen. Auch zu den Ausführungsvarianten, die zu den Figuren 4 und 5 erläutert wurden, könnte eine solche Querverbindung über eine entsprechende Querleitung 75 vorgesehen sein.

Figur 7 zeigt in den Unterfiguren a) und b) jeweils in einfacher Prinzipdarstellung alternative Ausführungsvarianten zu einer Acht-Kammer-Plasmastation. Auch in diesen Figuren ist im Wesentlichen der Leitungsverlauf innerhalb eines Kammersockels 30 angedeutet. An Anschluss 42 soll z.B. eine Pumpleitung einer ersten Pumpstufe an eine Versorgungsleitung 54 angeschlossen werden. Diese Versorgungsleitung 54 teilt sich in beiden dargestellten Varianten der Figuren 7a und 7b an einer Zweigstelle 55a 1. Ordnung in zwei Teilleitungen auf. Die Variante der Figur 7a setzt die an Zweigstellen stattfindende Aufteilung in jeweils zwei Unterleitungen fort, d. h. an Zweigstellen 55b 2. Ordnung teilen sich die Teilleitungen in insgesamt vier Unterteilleitungen auf, die bis zu Zweigstellen 55c 3. Ordnung verlaufen, wo sich die vier Unterteilleitungen auf insgesamt acht Unterunterteilleitungen 80 auffächern.

Demgegenüber sind in der Variante gemäß Figur 7b der Zweigstelle 55a 1. Ordnung nur zwei Zweigstellen 55b 2. Ordnung nachgeschaltet, von welchen aus jeweils vier Unterteilleitungen 80 abgehen, sodass ebenfalls jeweils eine Leitung in einer der acht Kavitäten der acht Plasmakammern münden kann oder z.B. auch im Innenraum einer darin angeordneten Flasche. Erneut sind - wie auch schon in Figur 6 - keinerlei Ventile eingezeichnet, welche z.B. in jeder der acht Unterunterteilleitungen 80 bzw. Unterteilleitungen 80 angeordnet sein könnten, und/oder aber in einer der vorhergehenden Teilleitungen.

Die Figuren 7a und 7b zeigen zudem Ausführungsbeispiele für Querleitungen, jeweils mit gestrichelter Linie dargestellt. Sowohl in Figur 7a als auch in Figur 7b ist eine erste Querleitung 75a erster Ordnung gezeigt, die die beiden Teilleitungen miteinander verbindet, zu denen sich die Versorgungsleitung 54 in der Zweigstelle 55a 1. Ordnung aufspaltet. Im Ausführungsbeispiel der Figur 7a ist eine Querleitung 75b 2. Ordnung dargestellt, welche alle vier Unterteilleitungen miteinander verbindet, d. h. die Querleitung 75b stellt eine Kommunikationsverbindung zwischen den vier Unterteilleitungen her, indem die Querleitung 75b jeweils im Bereich zwischen den Zweigstellen 2. und 3. Ordnung anschließen. Demgegenüber weist die Ausführungsvariante der Figur 7b zwei Querleitungen 75b 2. Ordnung auf, die jeweils gruppenweise die vier Unterteilleitungen miteinander verbinden, die von den beiden Zweigstellen 2. Ordnung abgehen.

Auch zu diesen beiden Ausführungsvarianten ist eine symmetrische Anordnung zu einer Spiegelebene vorteilhaft, in der die Hauptachse der Station liegt, weil sich auf diese Weise gleiche Strömungsverhältnisse bis hin zu allen Kammern erreichen lassen, denn dadurch ergeben sich auf konstruktiv einfache Art gleiche Weglängen, die bei Vorsehen gleicher Querschnitte zu gleichen Strömungswiderständen führen, sodass z.B. bei einem Verbinden mit einer ersten Pumpstufe in allen Plasmakammern mit guter Genauigkeit ein Gleichlauf beim Einstellen von Unterdruckbedingungen erreicht ist. Dies gilt in gleicher Weise, wenn über die dargestellten verzweigten Leitungen ein Belüften erfolgen soll. Diese Aussagen gelten sowohl für ein Abpumpen bzw. Belüften der Kavitäten der Plasmakammern, als auch für ein Abpumpen bzw. Belüften der in den Plasmakammern gehaltenen Behälter. Wenn eine gleiche Leitungslänge nicht möglich ist, ist bevorzugt ein sich daraus ergebender unterschiedlicher Strömungswiderstand durch angepasste Leitungsdurchmesser auszugleichen. Dies wird als weniger bevorzugte Lösung betrachtet, weil dies in der Herstellung aufwendiger ist, und weil dadurch ggf. an die Leitungsquerschnitte angepasste Ventile notwendig werden.

## Patentansprüche

1. Beschichtungsstation (1) für die Beschichtung von Werkstücken (5) in einem auf der Beschichtungsstation (1) ablaufenden Beschichtungsverfahren, insbesondere zur Beschichtung von Innenwänden von Behältern (5), insbesondere mittels eines PECVD-Verfahrens, insbesondere mittels eines mikrowelleninduzierten PECVD-Verfahrens,
wobei die Beschichtungsstation (1) wenigstens eine Beschichtungskammer (17) aufweist, die in einen geöffneten und einen geschlossenen Zustand überführbar ist und in die das zu beschichtende Werkstück (5) anordenbar ist zum Zwecke der Beschichtung, wobei die Kammer (17) von Kammerwänden (18, 29) gebildet ist, die Dichteinrichtungen (41) aufweisen, wobei die Kammer (17) dadurch im geschlossenen Zustand abgedichtet gegen die Außenumgebung verschließbar ausgeführt ist,
und wobei in der Kammer (17) bevorzugt Halte- und Dichtmittel (28) angeordnet sind, die ausgebildet sind, das Werkstück (5) innerhalb der Kammer (17) sowohl gegenüber der Umgebung als auch gegenüber der umgebenden Kammer (17) abgedichtet zu halten,
wobei die Beschichtungsstation (1) einen oder mehrere Anschlüsse (42) aufweist für den Anschluss an wenigstens eine Unterdruckquelle (44, 49) und/oder Druckausgleichsquelle, jeweils als Betriebsmediumquelle für ein Betriebsmedium bezeichnet,
wobei das Betriebsmedium und/oder alle Betriebsmedien innerhalb der Station (1) von dem Anschluss (42) bzw. von den Anschlüssen aus über eine zugeordnete, am Anschluss (42) beginnende Versorgungsleitung (54) für das Betriebsmedium zu der Kammer (17) und/oder zu dem Werkstück (5) geführt ist, wobei die Versorgungsleitung (54) dort ihr Leitungsende aufweist,
**dadurch gekennzeichnet, dass**
sich die Versorgungsleitung (54) an wenigstens einer Zweigstelle (55), die zwischen ihrem Leitungsanfang und ihrem Leitungsende angeordnet ist, in Teilleitungen (46, 70, 80) aufteilt, wobei in jeder Teilleitung (46, 70, 80) ein schaltbares Ventil (48) angeordnet ist.

2. Beschichtungsstation (1) nach Anspruch 1, **dadurch gekennzeichnet, dass** die Teilleitungen (46, 70, 80) entweder alle in der Kammer (17) oder alle im Werkstück (5) münden.

3. Beschichtungsstation (1) nach Anspruch 1 oder 2, **dadurch gekennzeichnet, dass** Länge und Durchmesser der Teilleitungen (46, 70, 80) so gewählt ist, dass der Strömungswiderstand des Betriebsmediums durch jede Teilleitung (46, 70, 80) gleich ist.

4. Beschichtungsstation (1) nach einem der Ansprüche 1 bis 3, wobei die Station (1) mehrere gleiche Beschichtungskammern (17) aufweist, **dadurch gekennzeichnet, dass** zu jeder Beschichtungskammer (17) und/oder zu jedem Werkstück (5) in der Beschichtungskammer eine der Teilleitungen (46, 70, 80) führt, wobei die Anordnung der Zweigstelle (55) und Länge und Durchmesser der Teilleitungen (46, 70, 80) so gewählt ist, dass der Strömungswiderstand des Betriebsmediums durch jede Teilleitung (46, 70, 80) gleich ist.

5. Beschichtungsstation (1) nach Anspruch 4, wobei die Station 2" gleiche Beschichtungskammern (17) aufweist, mit n als natürlicher Zahl und n größer 2, **dadurch gekennzeichnet, dass** die Teilleitungen (46) sich an Zweigstellen (55b) 2. Ordnung jeweils weiter in Unterteilleitungen (70, 80) aufteilen, und Unterteilleitungen (70, 80) zu jeder Kammer (17) oder zu jedem Werkstück (5) in den Kammern (17) führen, wobei die Länge und der Durchmesser der Unterteilleitungen (70, 80) so gewählt ist, dass der Strömungswiderstand des Betriebsmediums durch jede Unterteilleitung (70, 80) gleich ist.

6. Beschichtungsstation (1) nach einem der vorhergehenden Ansprüche, **dadurch gekennzeichnet, dass** alle Teilleitungen (46a, 46b) und/oder Unterteilleitungen (70, 80) untereinander einen gleichen Durchmesser aufweisen und von baugleichen Ventilen beherrscht sind.

7. Beschichtungsstation (1) nach einem der vorhergehenden Ansprüche, **dadurch gekennzeichnet, dass** die Ventile (46) elektronisch von einer Steuereinrichtung (45) ansteuerbar ausgeführt sind, wobei bevorzugt die kammerseitig nach einer Zweigstelle (55) in den Teilleitungen (46) bzw. Unterteilleitungen (70, 80) angeordneten Ventile (46) paarweise oder alle logisch verknüpft und virtuell zu einem Ventil zusammengefasst sind.

8. Beschichtungsstation (1) nach einem der vorhergehenden Ansprüche, **dadurch gekennzeichnet, dass** eine Querverbindungsleitung (75, 75a) vorgesehen ist, an der alle Teilleitungen (46) angeschlossen sind, und/oder eine Querverbindungsleitung (75b) vorgesehen ist, an der alle Unterteilleitungen (70, 80) angeschlossen sind.

9. Beschichtungsstation (1) nach Anspruch 2 oder einem der vorstehenden Ansprüche, soweit auf Anspruch 2 rückbezogen, **dadurch gekennzeichnet, dass** die Betriebsmediumquelle als eine Vakuumpumpstufe (44, 49) ausgeführt ist, die insbesondere ein Abpumpen ausgehend vom Umgebungsdruck ermöglichend ausgeführt ist.

10. Beschichtungsstation (1) nach einem der vorhergehenden Ansprüche, **dadurch gekennzeichnet, dass** die Betriebsmediumquelle als eine Druckausgleichsquelle ausgeführt ist und die Versorgungsleitung (54) ein Verbinden mit der Umgebung ermöglichend ausgebildet ist.

11. Beschichtungsstation (1) nach einem der vorhergehenden Ansprüche, **dadurch gekennzeichnet, dass** die Station (1) auf einem Beschichtungsrad (2) angeordnet ist, das zu einem kontinuierlich drehenden Umlauf antreibbar ausgebildet und angeordnet ist, wobei die Zweigstelle (55) in einem mit dem Beschichtungsrad (2) umlaufenden Bereich angeordnet ist, wobei insbesondere mehrere solcher Stationen (1) auf dem Beschichtungsrad (2) angeordnet sind, insbesondere in äquidistant umfangsverteilter Art.
